## Europäisches Patentamt
## European Patent Office
## Office européen des brevets

(19)

(11) Veröffentlichungsnummer : **0 025 612**
**B1**

(12)

# EUROPÄISCHE PATENTSCHRIFT

(45) Veröffentlichungstag der Patentschrift : 15.12.82

(21) Anmeldenummer : 80200657.7

(22) Anmeldetag : 07.07.80

(51) Int. Cl.³ : **H 01 L 23/48, H 01 L 23/04**

(54) Leistungs-Halbleiterbauelement mit einem Gehäuse.

(30) Priorität : 13.09.79 DE 2937049

(43) Veröffentlichungstag der Anmeldung : 25.03.81 (Patentblatt 81/12)

(45) Bekanntmachung des Hinweises auf die Patenterteilung : 15.12.82 Patentblatt 82/50

(84) Benannte Vertragsstaaten : CH DE FR GB LI SE

(56) Entgegenhaltungen : DE B 1 057 241 US A 2 927 953

(73) Patentinhaber : BBC Aktiengesellschaft Brown, Boveri & Cie.
Haselstrasse
CH-5401 Baden (CH)

(72) Erfinder : Holick, Hubert, Dipl.-Ing.
Planckstrasse 10
D-6840 Lampertheim (DE)
Erfinder : Jester, Alfred, Dipl.-Ing.
Friedrich-Hoelderlinweg 7
D-6720 Speyer (DE)

(74) Vertreter : Kempe, Wolfgang, Dr.
Postfach 1273
D-6800 Mannheim 1 (DE)

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Leistungs-Halbleiterbauelement mit einem Gehäuse

Die Erfindung betrifft ein Leistungs-Halbleiterbauelement mit einem Gehäuse, in dem eine mindestens einen pn-Übergang aufweisende Halbleiterscheibe über eine Vielzahl von zu einem bürstenähnlichen Bündel zusammengefaßten Leitern mit einer Metallscheibe, die zur Wärmeableitung und zur Stromzuführung dient, stoffschlüssig verbunden ist, wobei die Leiter an einer Stirnfläche des Bündels nur mit der Halbleiterscheibe jedoch nicht untereinander stoffschlüssig verbunden sind.

Ein derartiges Leistungs-Halbleiterbauelement ist aus der DE-A-28 55 493 bekannt. Die Einzeldrähte sind in Silikonkautschuk eingebettet und derart verdrillt, daß die außenliegenden Drähte länger sind als die innenliegenden. Da sich die mit den einen Enden der Drahtbürste stoffschlüssig, d.h. durch Löten, Schweißen oder Diffusionsbonden, verbundene Kupferscheibe beim Erwärmen stärker ausdehnt als die mit dem anderen Ende der Drahtbürste stoffschlüssig verbundene Siliziumscheibe, müssen die außenliegenden Einzeldrähte eine größere radiale Längendifferenz ausgleichen als die weiter innenliegenden. Beim Ausgleichen der radialen Längendifferenzen wird die Verdrillung der Einzeldrähte teilweise rückgängig gemacht, d.h. die in tangentialer Richtung verlaufende Länge wird teilweise in radiale Richtung verlaufende Länge umgewandelt, wobei der Abstand zwischen Halbleiterscheibe und Kupferscheibe gleich bleibt.

Aus der GB-A-876 133 ist ein federndes Kontaktelement bekannt, welches aus einem spiralig aufgewickelten, geschlitzten und im Bereich der Längsschlitze ausgebauchten Kupferband besteht. An ihrem oberen und unteren Ende ist die aufgewickelte Kupferbandspirale durch je eine aufgesetzte und angelötete Kappe zusammengehalten. Die eine der beiden Kappen ist mit einer metallischen Gegenelektrode und diese wiederum mit der Halbleiterscheibe verlötet. Das bekannte Kontaktelement kann somit lediglich axiale Wärmeausdehnungsdifferenzen ausgleichen ; radiale Wärmeausdehnungsdifferenzen werden durch die zwischen Kappe und Halbleiterscheibe gelötete Metallelektrode ausgeglichen. Aus diesem Grund ist das bekannte Halbleiterbauelement nur für relativ geringe Leistungen einsetzbar.

Aus der DE-A-15 14 149 ist eine weitgehend lötfreie Kontaktierung einer Halbleiterscheibe mit den äußeren Anschlußkontakten bekannt. Zu diesem Zweck ist auf die Halbleiterscheibe ein sogenanntes Multikontaktkissen, das aus einem feindrähtigen, filzartigen Metallpressling besteht, aufgepreßt. Es handelt sich somit um eine spezielle Form der Druckkontaktierung. Da die Siliziumscheibe sich beim Erwärmen in radialer Richtung wesentlich weniger stark ausdehnt als die Kupferkontaktscheibe bzw. das Multikontaktkissen, müssen die äußeren Drähte des Multikontaktkissens auf der Oberfläche der Siliziumscheibe rutschen. Dadurch ist eine Anwendung bei großflächigen Halbleiterbauelementen nicht möglich.

Nachdem es sich in der Vergangenheit herausgestellt hat, daß Lötverbindungen mit Halbleiterscheiben nur dann brauchbar sind, wenn die Halbleiterscheiben einen gewissen Durchmesser nicht überschreiten, hat sich in der Technik für Leistungs-Halbleiterbauelemente mit großflächigen Siliziumscheiben die Druckkontakttechnik allgemein durchgesetzt. Der Aufbau eines derartigen druckkontaktierten Halbleiterbauelementes ist beispielsweise aus der US-Zeitschrift « IEEE Transactions on Electron Devices » Vol. Ed-26, No 7, July 1979, Seiten 1 085 bis 1 091 bekannt. Wesentliches Merkmal druckkontaktierter Halbleiterbauelemente ist die Verwendung einer Molybdän-Scheibe und/oder einer Wolfram-Scheibe zwischen Siliziumscheibe und den als Wärmesenke dienenden Kupferscheiben. Molybdän und Wolfram haben thermische Ausdehnungskoeffizienten, die dem von Silizium nahekommen ; auf diese Weise wird die Oberfläche der Siliziumscheibe bei Wärmedehnungen wenig mechanisch beansprucht. Nachteilig ist bei dieser allgemein üblichen Druckkontakttechnik die geringe thermische Leitfähigkeit von Wolfram und insbesondere Molybdän sowie der schlechte, nur an wenigen Punkten bestehende Kontakt zwischen Silizium- und Wolfram- bzw. Molybdänscheibe. Dieser nur an wenigen Stellen bestehende Punktkontakt führt zu einer zusätzlichen Verschlechterung der Wärmeableitung von der Siliziumscheibe sowie zu einer Konzentrierung des elektrischen Stroms auf diese wenigen Kontaktpunkte. Die Autoren der angegebenen Literaturstelle Kommen anhand von theoretischen Überlegungen und praktischen Untersuchungen zu der Ansicht, daß durch eine Eliminierung der Punktkontakte zwischen Siliziumscheibe und aufliegenden Metallscheiben und zwischen den Metallscheiben untereinander die Stoßstromfestigkeit einer gegebenen Siliziumtablette um ca. 50 %, die Dauergleichstromfestigkeit um ca. 90 % erhöht werden könnte. Weitere dramatische Verbesserungen könnten erreicht werden, wenn es gelänge, die Wolfram- und Molybdänscheiben durch Kupferkühlkörper zu ersetzen. Es wird jedoch auch darauf hingewiesen, daß die dabei auftretenden bekannten, thermisch-mechanischen Probleme, wie das Reiben der Siliziumscheibe auf den Gehäuseteilen oder die Verhärtung der Lötverbindungen, mit den üblichen Mitteln nicht beherrscht werden konnten.

Der vorliegenden Erfindung liegt die Aufgabe zugrunde, für das eingangs beschriebene Leistungs-Halbleiterbauelement ein noch kostengünstiger herzustellendes Kontaktbündel anzugeben, das einen noch besseren Ausgleich unterschiedlicher radialer Ausdehnungen ermöglicht.

Diese Aufgabe wird dadurch gelöst, daß das Bündel aus einem zu einer Spirale aufgewickelten flachen Metallband besteht und daß das Metallband in regelmäßigen Abständen derart mit Querschlitzen versehen ist, daß eine Vielzahl von federnden Metallstegen gebildet ist, die einseitig durch ein an eine der nach Aufwicklung gebildeten Stirnflächen angrenzendes nichtgeschlitztes Teilstuck des Metallbandes miteinander verbunden sind.

Vorzugsweise sind die Querschlitze im Metallband gerade und das Metallband selbst ist mit einer im Querschnitt V-förmigen Sicke versehen.

Gemäß einer weiteren vorteilhaften Ausgestaltung sind die Querschlitze selbst V-förmig.

Damit ergeben sich die Vorteile, daß das Bürsten- bzw. Federpaket sehr einfach hergestellt werden kann, da das Kupferband in einem einfachen Durchlaufverfahren mit den erforderlichen Querschlitzen versehen werden kann. Das Aufrollen des bandes zu einer Spirale ist ebenfalls einfach und vollautomatisch durchführbar. Die radialen Dehnungsunterschiede zwischen Siliziumscheibe und Kühlkörper können aus der durch die V-Form bedingten Längenvorgabe der einzelnen Stege elastisch ausgeglichen werden. Ferner besitzt das erfindungsgemäße Bürsten- bzw. Federpaket auch in axialer Richtung federnde Eigenschaften ; es ist je nach Auslegung um einen Faktor 100 bis 1 000 elastischer als massives Kupfer. Toleranzen in der Planheit der Siliziumscheibe bzw. der Kupfer-Wärmeableitscheibe können überbrückt werden, so daß die Fertigungsgenauigkeit bei der Herstellung der Oberflächen verringert und damit die Fertigungskosten reduziert werden können. Über die Dicke und die Form der einzelnen federnden Stege kann die Steifigkeit des gesamten Pakets beliebig eingestellt werden. Wählt man beispielsweise die Federeigenschaften in axialer Richtung steif, so kann das fertige Halbleiterbauelement in bekannter Weise von außen mittels Druck kontaktiert werden, wobei jedoch die bisher verwendete Molybdän-Scheibe durch das erfindungsgemäße Bürstenpaket ersetzt wird. Gleichzeitig können die erforderlichen äusseren Anpreßkräfte reduziert werden.

Ein wesentlicher Vorteil des erfindungsgemäßen Kontaktes liegt jedoch in dem verringerten thermischen und elektrischen Übergangswiderstand, der durch die stoffschlüssige Verbindung zwischen Siliziumscheibe und Federkontakt bedingt ist. Die stoffschlüssige Verbindung jedes einzelnen Steges mit der Siliziumscheibe führt außerdem zu einem über die gesamte Kontaktfläche gleichmäßigen Stromübergang, was wiederum zu einem wesentlich günstigeren Stoßstromverhalten führt.

Vorzugsweise sind die Querschlitze in das Metallband gestanzt oder geätzt. Insbesondere das Ätzverfahren ist für einen automatischen Herstellungsvorgang geeignet.

Gemäß einer vorteilhaften Ausgestaltung sind die von den nicht geschlitzten Teilstücken des Metallbandes sowie von den Metallstege in gebildeten Stirnflächen mit einer ihre mechanische Verbindbarkeit fördernden Beschichtung versehen sind. Dies kann beispielsweise dadurch geschehen, daß die Stirnflächen mit Lot beschichtet werden, wenn eine Lötverbindung geplant ist, oder mit Gold, wenn eine Diffusionsbondung vorgesehen ist.

Um zu verhindern, daß die einzelnen federnden Stege auch untereinander eine kraftschlüssige Verbindung eingehen, sind deren Oberflächen vorzugsweise lotabweisend behandelt. Diese lotabweisende Schicht kann beispielsweise bestehen aus Kohlenstoff, aus Aluminium, aus einem Oxid oder einem anderen, benetzungsfeindlichen Material.

Vorzugsweise ist die von den nicht geschlitzten Teilstück des Metallbandes gebildete Stirnfläche mit der Metallscheibe stoffschlüssig verbunden. Diese Art der Verbindung ist besonders dann von Vorteil, wenn das Metallband ebenso wie die Metallscheibe aus Kupfer oder einer Kupferlegierung besteht. Dann entstehen zwischen Metallscheibe und Metallband keine thermischen Ausdehnungsdifferenzen.

Vorzugsweise ist die Breite der Querschlitze wesentlich kleiner als die Dicke des Metallbandes. Auf diese Weise erreicht man einen besonders hohen Anteil von Metall in dem erfindungsgemäßen Verbindungselement, wodurch der thermische und elektrische Übergangswiderstand dem von kompaktem Metall nahekommt.

Anhand der Zeichnung soll die Erfindung in Form von Ausführungsbeispielen näher erläutert werden.

Es zeigen :

Figur 1 ein Diagramm, aus dem die temperaturbedingten Ausdehnungsdifferenzen von Silizium und Kupfer entnehmbar sind,

Figure 2 und 3 eine erste Ausführungsform eines Metallbandes,

Figure 4 und 5 eine zweite Ausführungsform eines Metallbandes,

Figur 6 in schematischer Darstellung einen Querschnitt durch eine Leistungs-Halbleiterbauelement bei Verwendung des ersten Metallbandes,

Figur 7 in schematischer Darstellung einen Querschnitt durch ein Leistungs-Halbleiterbauelement bei Verwendung des zweiten Metallbandes.

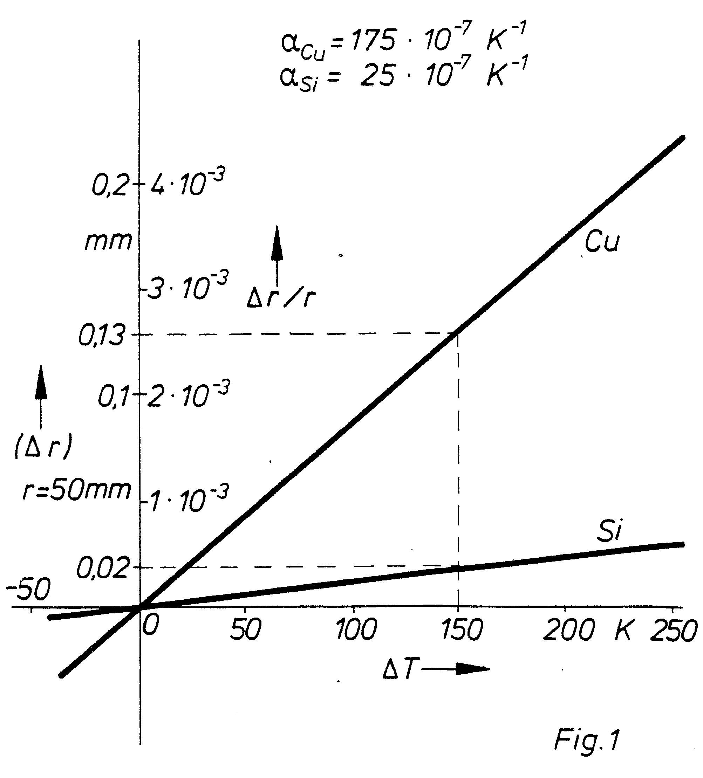

In Fig. 1 erkennt man ein rechtwinkliges Koordinatensystem, auf dessen Abszisse die Temperaturdifferenz T in Kelvin und auf dessen Ordinate in der rechten Skala die relative Vergrößerung $\Delta r/r$ einer Scheibe mit dem radius r und auf dessen linker Skala die absolute Längenänderung $\Delta r$ in Millimeter für eine Scheibe mit Radius r = 50 mm aufgetragen sind. Man erkennt, daß bei der als Beispiel eingetragenen Temperaturerhöhung $\Delta T = 150$ K eine Silizium-Scheibe ihren Radius um 0,02 mm, eine gleichgroße Kupferscheibe ihren Radius um 0,13 mm vergrößert. Die Radiusdifferenz von 0,11 mm muß von den Verbindungsglied zwischen Kupferscheibe und Siliziumscheibe aufgenommen werden, ohne daß dabei eines der beteiligten Elemente mechanisch zerstört oder der elektrische und thermische Übergang behindert wird.

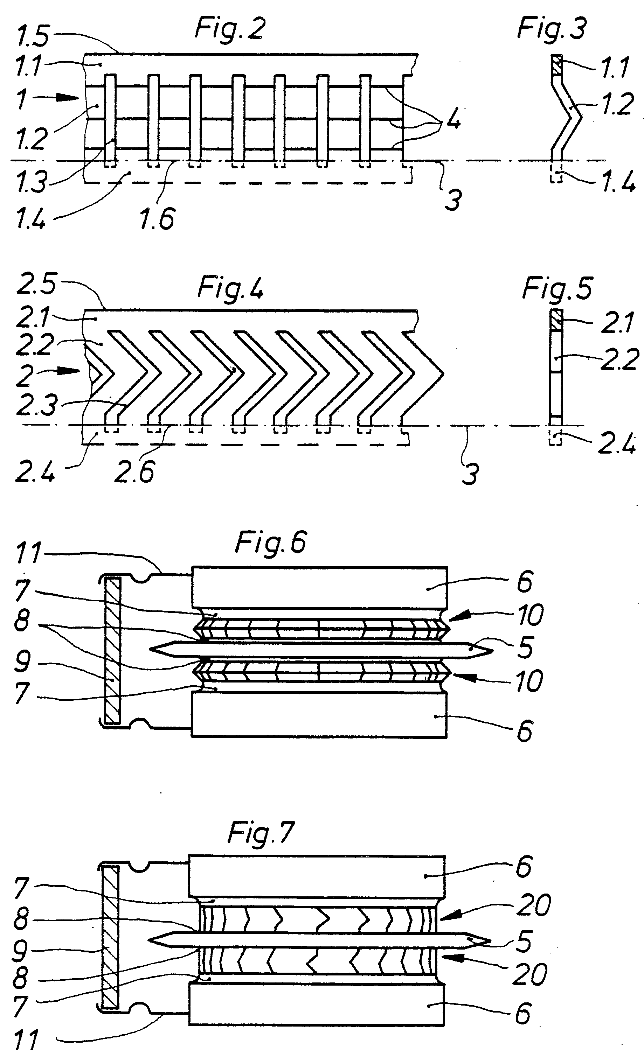

Fig. 2 in Draufsicht und Fig. 3 in Seitenansicht zeigen eine erste Ausführungsform eines Metallbandes, das, nachdem es zu einer Spirale aufgewickelt ist, eine gute und elastische Verbindung zwischen einer Siliziumscheibe und einer Kupfer-Wärmeableitscheibe herstellt. Das Metallband 1 ist in regelmäßigen Abständen mit Querschlitzen 1.3 versehen, zwischen denen metallische, federnde Stege 1.2 stehen bleiben, die an ihrem oberen Ende durch ein nicht geschlitztes Teilstück 1.1 zusammengehalten werden. Während der Herstellung der Schlitze ist auch am unteren Ende des Metallbandes 1 ein nicht geschlitztes Metallstück 1.4 vorhanden, das jedoch später entlang einer Trennlinie 3 abgetrennt wird. Entlang den Biegelinien 4 ist das Metallband 1 so abgewinkelt, daß sich eine im Querschnitt V-förmige Sicke ergibt, wie es in Figur 3 gezeigt ist. Die obere Stirnfläche 1.5 des Metallbandes 1 wird später mit einer Wärmeableitscheibe, die untere Stirnfläche 1.6 der Metallstege 1.2 mit einer Siliziumscheibe stoffschlüssig verbunden. Die durch die unterschiedlichen Ausdehnungskoeffizienten bedingte Längendifferenz wird von der V-förmigen Sicke aufgenommen, indem sich die federnden Stege 1.2 entsprechend strecken oder beugen.

Fig. 4 in Draufsicht und Fig. 5 in Seitenansicht zeigen eine weitere Ausführungsform eines Metallbandes. Das Metallband 2 ist mit einer Reihe von V-förmigen Querschlitzen 2.3 versehen, zwischen denen ebenfalls V-förmige Metallstege 2.2 stehen bleiben, die an ihrem oberen Ende von einem nicht geschlitzten Teilstück 2.1 des Metallbandes 2 zusammengehalten werden. Ein ebenfalls nicht geschlitztes Stück 2.4 des Metallbandes 2 am unteren Ende wurde entlang der Trennlinie 3 abgetrennt, so daß die Metallstege 2.2 an ihrem unteren Ende frei sind. Wie Figur 5 zeigt, bleibt das Metallband 2 eben. Die radiale Ausdehnungsdifferenz zwischen einer an der oberen Stirnfläche 2.5 befestigten Wärmeableitscheibe und einer an der unteren Stirnfläche 2.6 der Stege 2.2 befestigten Siliziumscheibe wird durch die V-Form der Metallstege 2.2 ausgeglichen, indem sich die Metallstege 2.2 mehr oder weniger stark verwinden.

Fig. 6 zeigt ein fertig montiertes Leistungs-Halbleiterbauelement. Man erkennt ein Gehäuse 9 aus Isoliermaterial, an dem über Metallringteile 11 Metallscheiben 6 befestigt sind, die zur Abfuhr der Wärme sowie zur Zufuhr von Strom und Spannung dienen. Mit den Metallscheiben 6, die beispielsweise aus Kupfer bestehen, ist über eine Lötverbindung 7 das zu einer Spirale 10 aufgewickelte Metallband 1 befestigt. Die Stirnflächen der Stege sind über eine weitere Lötverbindung 8 mit Kontaktflächen einer Silizium-Tablette 5 stoffschlüssig verbunden. Es ist leicht einzusehen, daß durch das Aufwickeln von mehr oder weniger Metallband die Größe der Spirale 10 der Größe der zu kontaktierenden Flächen auf Siliziumscheibe 5 oder Wärmeableitscheibe 6 angepaßt werden kann. Auch ist es möglich, im Zentrum der Spirale 10 eine Öffnung zu lassen, durch die das Zentral-Gate eines Thyristors kontaktiert werden kann.

Fig. 7 zeigt eine ähnliche Ausführungsform, bei der die eine Spirale 20 als Zwischenglied zwischen Wärmeableitscheibe 5 und Siliziumscheibe 6 verwendet wird, die aus einem Metallband 2 hergestellt wurde. man erkennt zudem, daß der Wicklungssinn der oberen Spirale 20 dem Wicklungssinn der unteren Spirale 20 entgegengesetzt ist. Auf diese Weise kann die Siliziumscheibe 5 bei einer Ausdehnungsdifferenz zwischen Halbleiterscheibe und Wärmeableitscheibe eine Drehbewegung ausführen, durch die ein Teil der in den federnden Stegen des Metallbandes 2 entstehenden mechanischen Spannungen abgebaut wird.

Zur Herstellung des erfindungsgemäßen Verbindungselements wird ein Kupferband geeigneter Breite durch Stanzen oder Ätzen mit den Querschlitzen und gegebenenfalls der V-förmigen Sicke versehen. Zu diesem Zeitpunkt sind die federnden Stegen an beiden Enden noch durch ein ungeschlitztes Teilstück des Metallbandes verbunden. Anschließend wird das Band spiralig aufgewickelt und durch Löten, Schweißen oder Diffusionsbonden mit einer Kupferscheibe stoffschlüssig verbunden. Anschließend wird die freie Stirnfläche der Spirale abgeschliffen, bis die einzelnen federnden Stege frei stehen. Anschließend werden die Stirnfläche der Stege für die Verbindung mit der Siliziumscheibe vorbereitet, indem beispielsweise Gold oder Lot aufgebracht wird. Die so vorbereiteten Stirnflächen werden auf eine entsprechend vorbereitete Oberfläche der Siliziumscheibe aufgeklebt und mittels Wärme und Druck stoffschlüssig mit dieser verbunden. Da jeder einzelne Steg für sich federnd ist, kann er kleine Längendifferenzen, die durch eine nicht vollkommene Oberflächenbearbeitung der Siliziumscheibe oder der Kupferspirale bedingt sind, ohne weiteres ausgleichen. Um zu verhindern, daß unter dem Einfluß von Druck und Wärme erweichendes Lot auch die haarfeinen Zwischenräume zwischen der einzelnen federnden Stegen hochkriecht, werden die Seitenflächen der Stege mit einem lotabweisenden Material beschichtet.

**Ansprüche**

1. Leistungs-Halbleiterbauelement mit einem Gehäuse (9), in dem eine mindestens einen pn-Übergang aufweisende Halbleiterscheibe (5) über eine Vielzahl von zu einem bürstenähnlichen Bündel (10 ; 20) zusammengefaßten Leitern mit einer Metallscheibe (6), die zur Wärmeableitung und zur Stromzuführung dient, stoffschlüssig verbunden ist, wobei die leiter an einer Stirnfläche des Bündels nur mit der Halbleiterscheibe (5) jedoch nicht untereinander stoffschlüssig verbunden sind, dadurch gekennzeichnet, daß das Bündel (10 ; 20) aus einem zu einer Spirale aufgewickelten flachen Metallband (1 ; 2) besteht und daß das Metallband (1 ; 2) in regelmäßigen Abständen derart mit Querschlitzen (1.3 ; 2.3) versehen ist, daß eine Vielzahl von federnden Metallstegen (1.2 ; 2.2) gebildet ist, die einseitig durch ein an eine der nach Aufwicklung gebildeten Stirnflächen angrenzendes, nicht geschlitztes Teilstück (1.1 ; 2.1) des Metallbandes (1 ; 2) miteinander verbunden sind.

2. Leistungs-Halbleiterbauelement nach Anspruch 1, dadurch gekennzeichnet, daß die Querschlitze (1.3) gerade sind.

3. Leistungs-Halbleiterbauelement nach Anspruch 1 oder 2, dadurch gekennzeichnet, daß das Metallband (1) mit einer im Querschnitt V-förmigen Sicke (Fig. 3) versehen ist.

4. Leistungs-Halbleiterbauelement nach Anspruch 1, dadurch gekennzeichnet, daß die Querschlitze (2.3) V-förmig sind.

5. Leistungs-Halbleiterbauelement nach einem der Ansprüche 1 bis 4, dadurch gekennzeichnet, daß die Querschlitze (1.3 ; 2.3) in das Metallband (1 ; 2) gestanzt sind.

6. Leistungs-Halbleiterbauelement nach einem der Ansprüche 1 bis 4, dadurch gekennzeichnet, daß die Querschlitze (1.3 ; 2.3) in das Metallband geätzt sind.

7. Leistungs-Halbleiterbauelement nach einem der Ansprüche 1 bis 6, dadurch gekennzeichnet, daß die von dem nicht geschlitzten Teilstück des Metallbandes sowie von den Metallstegen gebildeten Stirnflächen (1.5, 1.6 ; 2.5, 2.6) mit einer ihre mechanische Verbindbarkeit fördernden Beschichtung versehen sind.

8. Leistungs-Halbleiterbauelement nach einem der Ansprüche 1 bis 7, dadurch gekennzeichnet, daß die Oberflächen der Metallstege (1.2 ; 2.2) lotabweisend behandelt sind.

9. Leistungs-Halbleiterbauelement nach einem der Ansprüche 1 bis 8, dadurch gekennzeichnet, daß die von dem nicht geschlitzten Teilstück (1.1 ; 2.1) des Metallbandes (1 ; 2) gebildete Stirnfläche (1.5 ; 2.5) mit der Metallscheibe (6) stoffschlüssig verbunden ist.

10. Leistungs-Halbleiterbauelement nach einem der Ansprüche 1 bis 9, dadurch gekennzeichnet, daß das Metallband (1 ; 2) aus Kupfer oder einer Kupferlegierung besteht.

11. Leistungs-Halbleiterbauelement nach einem der Ansprüche 1 bis 10, dadurch gekennzeichnet, daß die Breite der Querschlitze (1.3 ; 2.3) wesentlich kleiner ist als die Dicke des Metallbandes (1, 2).

## Claims

1. A power semiconductor device with a casing (9), in which a semiconductor disc (5) having at least one pn junction is positively connected — by way of a plurality of conductors combined to form a brush-like bundle (10 ; 20) — to a metal disc (6) which is used to remove heat and to supply current, the conductors at one end face of the bundle being positively connected only to the semiconductor disc (5) but not to one another, characterized in that the bundle (10 ; 20) consists of a flat metal strip (1 ; 2) wound up to form a spiral, and the metal strip (1 ; 2) is provided with transverse slots (1.3 ; 2.3) at regular intervals in such a way that a plurality of resilient metal webs (1.2 ; 2.2) are formed which are connected together at one end by a part (1.1 ; 2.1) of the metal strip (1 ; 2) which is not slotted and which is adjacent to one of the end faces formed after winding.

2. A power semiconductor device according to Claim 1, characterized in that the transverse slots (1.3) are straight.

3. A power semiconductor device according to Claim 1 or 2, characterized in that the metal strip (1) is provided with a corrugation (Fig. 3) which is V-shaped in cross-section.

4. A power semiconductor device according to Claim 1, characterized in that the transverse slots (1 ; 2) are V-shaped.

5. A power semiconductor device according to any one of Claims 1 to 4, characterized in that the transverse slots (1.3 ; 2.3) are punched in the metal strip (1 ; 2).

6. A power semiconductor device according to any one of Claims 1 to 4, characterized in that the transverse slots (1.3 ; 2.3) are etched in the metal strip (1 ; 2).

7. A power semiconductor device according to any one of Claims 1 to 6, characterized in that the end faces (1.5, 1.6 ; 2.5, 2.6) formed by the part of the metal strip that is not slotted and by the metal webs are provided with a coating which improves their mechanical connectibility.

8. A power semiconductor device according to any one of Claims 1 to 7, characterized in that the surfaces of the metal webs (1.2 ; 2.2) are treated so as to repel solder.

9. A power semiconductor device according to any one of Claims 1 to 8, characterized in that the end face (1.5 ; 2.5) formed by the part (1.1 ; 2.1) of the metal strip (1 ; 2) that is not slotted is positively connected to the metal disc (6).

10. A power semiconductor device according to any one of Claims 1 to 9, characterized in that the metal strip (1 ; 2) consists of copper or a copper alloy.

11. A power semiconductor device according to any one of Claims 1 to 10, characterized in that the width of the transverse slots (1.3 ; 2.3) is substantially less than the thickness of the metal strip (1 ; 2).

## Revendications

1. Composant semi-conducteur de puissance comportant une enveloppe (9) dans laquelle un disque semi-conducteur (5) présentant au moins une jonction pn est relié de matière par l'intermédiaire de plusieurs conducteurs rassemblés en un faisceau du type brosse (10 ; 20), un disque métallique (6) servant à la dissipation thermique et à l'arrivée du courant, les conducteurs étant alors reliés de matière sur une face frontale du faisceau seulement au disque semi-conducteur (5) mais non entre eux, caractérisé en ce que le faisceau (10 ; 20) est constitué par une bande métallique plate (1 ; 2) enroulée en une spirale et en ce que la bande métallique (1 ; 2) est munie à des distances uniformes de fentes transversales (1.3 ; 2.3) de telle manière que soient formées plusieurs traverses métalliques élastiques (1.2 ; 2.2) qui sont réunies les unes aux autres d'un côté par une portion (1.2 ; 2.1) non fendue de la bande métallique (1 ; 2) limitant l'une des faces frontales formées après enroulement.

2. Composant semi-conducteur de puissance selon la revendication 1, caractérisé en ce que les fentes transversales (1.3) sont droites.

3. Composant semi-conducteur de puissance selon la revendication 1 ou 2, caractérisé en ce que la bande métallique (1) est munie d'une moulure en forme de V (Fig. 3) en section transversale.

4. Composant semi-conducteur de puissance selon la revendication 1, caractérisé en ce que les fentes transversales (2.3) sont en forme de V.

5. Composant semi-conducteur de puissance selon l'une des revendications 1 à 4, caractérisé en ce que les fentes transversales (1.3 ; 2.3) sont estampées dans la bande métallique (1 ; 2).

6. Composant semi-conducteur de puissance selon l'une des revendications 1 à 4, caractérisé en ce que les fentes transversales (1.3 ; 2.3) sont fabriquées par attaque chimique dans la bande métallique.

7. Composant semi-conducteur de puissance selon l'une des revendications 1 à 6, caractérisé en ce que les faces frontales (1.5, 1.6 ; 2.5, 2.6) formées par la portion non fendue de la bande métallique ainsi que par les traverses métalliques sont munies d'un revêtement favorisant leur capacité de liaison mécanique.

8. Composant semi-conducteur de puissance selon l'une des revendications 1 à 7, caractérisé en ce que les surfaces des traverses métalliques (1.2 ; 2.2) sont traitées pour être incompatibles avec un métal d'apport.

9. Composant semi-conducteur de puissance selon l'une des revendications 1 à 8, caractérisé en ce que la face frontale (1.5 ; 2.5) formée par la portion non fendue (1.1 ; 2.1) de la bande métallique (1 ; 2) est reliée de matière au disque métallique (6).

10. Composant semi-conducteur de puissance selon l'une des revendications 1 à 9, caractérisé en ce que la bande métallique (1 ; 2) est en cuivre ou en un alliage de cuivre.

11. Composant semi-conducteur de puissance selon l'une des revendications 1 à 10, caractérisé en ce que la largeur des fentes transversales (1.3 ; 2.3) est sensiblement plus faible que l'épaisseur de la bande métallique (1, 2).

$$\alpha_{Cu} = 175 \cdot 10^{-7}\ K^{-1}$$
$$\alpha_{Si} = 25 \cdot 10^{-7}\ K^{-1}$$

Fig.1

Fig.2  Fig.3  Fig.4  Fig.5  Fig.6  Fig.7